# FASCICULE DE BREVET EUROPEEN

(11) **EP 0 756 967 B1**
(45) Date de publication et mention de la délivrance du brevet: **23.02.2000**
(21) Numéro de dépôt: 96401330.4
(22) Date de dépôt: 19.06.1996
(51) Int. Cl.: B60Q 3/04

(54) **Indicateur pour tableau de bord**
Anzeigegerät am Armaturenbrett
Indicating device for vehicle dashboard

(30) Priorité: 05.07.1995 FR 9508133
(43) Date de publication de la demande: 05.02.1997
(73) Titulaire: SAGEM SA, 75783 Paris Cédex 16 (FR)
(72) Inventeur: Metais, Derry, 95650 Genicourt (FR)
(74) Mandataire: Bloch, Gérard

(56) Documents cités:
- EP-A- 0 602 385
- EP-A- 0 616 922
- DE-A- 4 343 202
- GB-A- 2 018 485

## Description

L'invention concerne un indicateur pour tableau de bord selon le préambule de la revendication. Un tel indicateur est décrit dans le document EP-A-0 616 922.

Un indicateur pour tableau de bord de véhicule automobile, comprenant une carte de circuit imprimé et une face avant, comporte généralement un mouvement, ou moteur, relié électriquement au circuit imprimé, avec un arbre de sortie sur lequel est montée une aiguille, la face avant portant un film sérigraphié faisant fonction de cadran pour l'aiguille et des moyens étant prévus pour éclairer l'aiguille et le film sérigraphié.

Dans les solutions classiques, on utilise des conduits optiques et des sources à incandescence pour l'éclairage de l'aiguille et du film sérigraphié, celui-ci étant de surcroît éclairé par transparence à travers la face avant.

Les conduits optiques sont coûteux et de mise en oeuvre complexe ; le rendement optique de l'ensemble est médiocre en intensité et l'homogénéité de la luminance tout à fait moyenne ; les conduits optiques augmentent l'encombrement.

La présente invention vise à proposer une solution ne présentant pas les inconvénients ci-dessus et basée sur un éclairage par LED CMS (diodes électroluminescentes montées en surface).

A cet effet, l'invention concerne un indicateur pour tableau de bord de véhicule tel que revendiqué dans la revendication.

Il est observé que dans le document EP-A-0 616 922 le pan tronconique du conduit optique ne s'ouvre pas vers l'aiguille mais vers la face arrière du conduit optique.

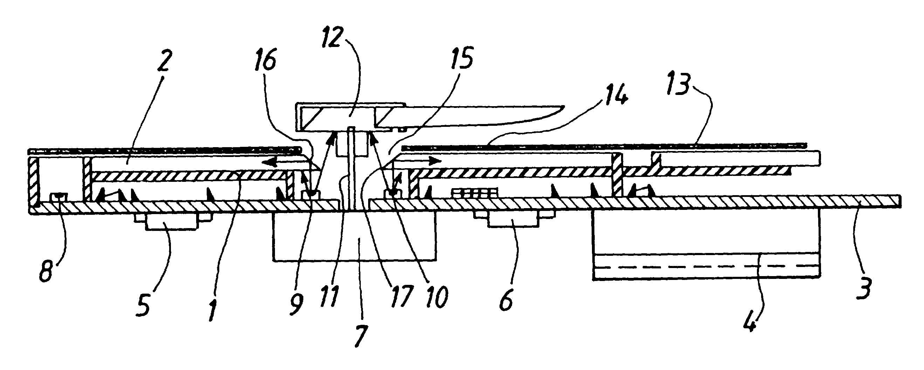

L'invention sera mieux comprise à l'aide de la description suivante de la réalisation d'un tableau de bord dans lequel est monté l'indicateur de l'invention, en référence au dessin annexé sur lequel le tableau est représenté en coupe simplifiée.

Soit un indicateur d'un tableau de bord, en l'espèce d'un véhicule automobile, qui comprend un boîtier 1, ici en ABS (acrylo-butadiène-styrène), une face avant 2, ici surmoulée sur le boîtier 1 et en polycarbonate ou PMMA (polyméthacrylate de méthyle), et une carte de circuit imprimé 3 portant, d'un côté, des composants tels qu'un connecteur 4, des composants discrets 5, 6, le mouvement 7 de l'indicateur considéré et, de l'autre côté, qui est celui de la soudure des composants, des LED CMS 8, 9, 10.

Le mouvement, ou moteur, 7 de l'indicateur est relié électriquement au circuit imprimé 3 et son arbre de sortie 11 porte une aiguille 12; le cadran de l'indicateur est constitué par une portion 14 d'un film sérigraphié 13 rapporté sur le côté avant de la face avant 2.

L'arbre 11 du mouvement 7 s'étend à travers une ouverture circulaire 15 ménagée dans la face avant 2 et comportant un bord intérieur annulaire 16 qui est biseauté, tronconique, ouvert vers l'avant, c'est-à-dire vers l'aiguille 12 et qui forme un pan réflectif.

Ce sont des LED 9, 10 qui éclairent l'aiguille 12 et le cadran 14, par l'intermédiaire de la face avant 2.

Grâce à la disposition du pan réflectif 16 et à la disposition sous ce pan 16, c'est-à-dire juste à l'arrière de celui-ci, des LED 9, 10, la lumière de ces LED frappe le pan 16 qui la réfléchit avant qu'elle ne soit drainée dans l'épaisseur de la face avant 2 vers l'extérieur, la face avant constituant ainsi un conduit optique pour le cadran 14. Cette fonction de conduit optique d'éclairage pour le cadran est exercée à titre principal.

A titre résiduel, les faisceaux des LED 9, 10 sont réfractés sur le bord arrière 17 du pan 16 proche des LED et l'aiguille 12 est ainsi éclairée par fuite de lumière.

On remarquera que la profondeur du tableau de bord, entre la carte 3 et l'aiguille 12, est relativement faible. De surcroît, l'éclairage de l'aiguille 12 et de son cadran 14 est réalisé au moyen de très peu de sources de lumière.

## Revendications

1. Indicateur pour tableau de bord de véhicule, l'indicateur comprenant une face avant (2), comportant un mouvement (7) avec une aiguille (12), la face avant (2) portant un cadran indicateur (13, 14) et des moyens d'éclairage étant prévus pour éclairer l'aiguille et le cadran et comprenant des LED CMS (9, 10) et les LED (9, 10), la face avant (2) et l'aiguille (12) étant agencées pour que la face avant fasse de façon principale office de conduit optique pour le cadran (13, 14) et, de façon rédisuelle, éclaire l'aiguille (12), la face avant comprenant un pan tronconique réflectif (16), caractérisé par le fait que le pan tronconique réflectif (16) s'ouvre vers l'aiguille (12) et les LED (9, 10) sont disposées pour que leurs faisceaux lumineux frappent un pan tronconique réflectif (16) et l'aiguille (12) est éclairée par réfraction et fuite de lumière sur le bord, proche des LED (9, 10), du pan tronconique réflectif (16) de la face avant (2).

## Patentansprüche

1. Anzeigevorrichtung für ein Fahrzeug-Armaturenbrett, wobei die Anzeigevorrichtung eine Frontseite (2) und einen Antrieb (7) mit einem Zeiger (12) aufweist, wobei die Frontseite (2) eine Anzeigeskala (13, 14) und Leuchtmittel zum Beleuchten des Zeigers und der Skala trägt und LED CMSs (9, 10) aufweist, wobei die LEDs (9, 10), die Frontseite (2) und der Zeiger (12) derart angeordnet sind, daß die Frontseite vorwiegend als Lichtleiter für die Skala wirkt und im übrigen den Zeiger (12) beleuchtet, wobei die Frontseite eine kegelstumpfförmige Reflexionsfläche (16) aufweist, dadurch gekennzeichnet, daß sich die kegelstumpfförmige Reflexionsfläche (16) in Richtung auf den Zeiger (12) hin öffnet und daß die LEDs (9, 10) derart angeordnet sind, daß ihre Lichtstrahlen auf die kegelstumpfförmige Reflexionsfläche (16) treffen und daß der Zeiger (12) durch Brechung und Streuung des Lichts am Rand der kegelstumpfförmigen Reflexionsfläche (16) der Frontseite (2) nahe den LEDs (9, 10) beleuchtet ist.

## Claims

1. Indicator for a vehicle dash-board, the indicator comprising a front side (2), comprising a movement (7) with a pointer (12), the front side (2) comprising an indicator dial (13, 14) and illumination means being provided for illuminating the pointer and the dial and comprising CMS LEDs (9, 10) and the LEDs (9, 10), the front side (2) and the pointer (12) being arranged in order that the front side principally acts as an optical conduit for the dial (13, 14) and, residually, illuminates the pointer (12), the front side comprising a reflective frustoconical face (16), characterised by the fact that the reflective frustoconical face (16) opens towards the pointer (12) and the LEDs (9, 10) are disposed so that their light beams strike a reflective frustoconical face (16) and the pointer (12) is illuminated by refraction and leakage of light on the edge, close to the LEDs (9, 10), of the reflective frustoconical face (16) of the front side (2).
